**Europäisches Patentamt**

**European Patent Office**

**Office européen des brevets**

(19)

(11) Veröffentlichungsnummer: **0 287 843**
**B1**

(12)

# EUROPÄISCHE PATENTSCHRIFT

(45) Veröffentlichungstag der Patentschrift:
29.08.90

(51) Int. Cl.⁵: **C23C 18/16**

(21) Anmeldenummer: **88104882.1**

(22) Anmeldetag: **25.03.88**

(54) **Verfahren zur Herstellung von Leiterplatten.**

(30) Priorität: **24.04.87 DE 3713792**

(43) Veröffentlichungstag der Anmeldung:
**26.10.88 Patentblatt 88/43**

(45) Bekanntmachung des Hinweises auf die Patenterteilung:
**29.08.90 Patentblatt 90/35**

(84) Benannte Vertragsstaaten:
**AT BE CH DE FR GB IT LI NL**

(56) Entgegenhaltungen:
**EP-A- 0 180 101**
**EP-A- 0 182 193**

**RCA REVIEW, Band 31, Nr. 2, Juni 1970, Seiten 439-442, US; N. FELDSTEIN et al.: "Selective electroless plating by selective deactivation"**

(73) Patentinhaber: **Siemens Aktiengesellschaft, Wittelsbacherplatz 2, D-8000 München 2(DE)**

(72) Erfinder: **Mattelin, Antoon, Dipl.-Ing., Leliestraat 6, B-08020 Oostkamp(BE)**

## Beschreibung

Die Erfindung betrifft ein Verfahren zur Herstellung von Leiterplatten in Additivtechnik nach dem Oberbegriff des Anspruchs 1.

Beim Aufbau von gedruckten Schaltungen bzw. Leiterplatten unterscheidet man grundsätzlich die weitverbreitete Subtraktivtechnik, die von metallkaschierten Substraten bzw. Basismaterialien ausgeht und das nicht für Leiterzüge benötigte Kupfer durch Ätzung entfernt, von der Additivtechnik, die, auf haftvermittlerbeschichteten Substraten aufbauend, das Leitermaterial nur dort aus Bädern aufbringt, wo Leiterzüge benötigt werden. Auch Kombinationen dieser Verfahren sind üblich. So wird bei der Durchkontaktierung, d.h. der Kuperbelegung der Lochwandung von beidseitig vorhandenen - subtraktiv hergestellten - Leiterbildern additiv gearbeitet. In der Semiadditivtechnik werden auf stromlos abgeschiedene, dünne Grundschichten die Leiterbahnen durch galvanische Verstärkung aufgebaut und die restliche Grundschicht durch Ätzen, d.h. subtraktiv, wieder entfernt (vergleiche AEG-Telefunken Handbücher, Band 22, "Kunststoffe in der Elektrotechnik", 1979, Seite 36).

Aus der DE-Z "Galvanotechnik" 77, (1986), Nr. 1, Seiten 51 bis 60 ist es auch bereits bekannt, bei der Herstellung von Leiterplatten in Volladditivtechnik die Leiterbildübertragung mit Hilfe eines Lasers vorzunehmen. Grundsätzlich wurden hierzu folgende Übertragungsmechanismen in Betracht gezogen und untersucht:
- direkte Anregung der Substratoberfläche oder eines Haftvermittlers durch den Laserstrahl;
- thermische oder fotochemische Anregung oder Desaktivierung einer Aktivatorschicht durch den Laserstrahl;
- Initiierung und Beschleunigung der außenstromlosen oder galvanischen Metallabscheidung durch die thermische Energie des Laserstrahls.
Dabei erschien von den untersuchten Übertragungsmechanismen ein Cr (III)-Schichtaktivierungssystem für eine weitere Verfahrensoptimierung am besten geeignet.

Der Erfindung liegt die Aufgabe zugrunde, ein umweltfreundliches Verfahren zur Herstellung von Leiterplatten in Additivtechnik zu schaffen, das eine einfache Übertragung auch sehr feiner Leiterstrukturen mit guter Haftgrundlage gewährleistet und auch bei der Herstellung von Durchkontaktierungen keine Probleme aufwirft.

Diese Aufgabe wird bei einem gattungsgemäßen Verfahren durch die kennzeichnenden Merkmale des Anspruchs 1 gelöst.

Der Erfindung liegt die Erkenntnis zugrunde, daß durch Ablation mittels elektromagnetischer Strahlung ein negatives Bild der Leiterzüge erzeugt werden kann, wobei die Bekeimung, die aktivierte Bekeimung oder ein dünner Hauch chemisch aufgebrachten Metalls ohne wesentliche Beeinträchtigung der Substratoberfläche selektiv wieder abgetragen wird. Im Bereich der Einwirkung der elektromagnetischen Strahlung kann dann bei den nachfolgenden Verfahrensschritten keine Metallisierung mehr stattfinden. Unter Wahrung der Vorteile der Additivtechnik kann bei dem erfindungsgemäßen Verfahren also eine besonders einfach zu realisierende Leiterbildübertragung mittels elektromagnetischer Strahlung vorgenommen werden. Im Hinblick auf die Erzeugung eines negativen Leiterbildes bereitet auch die Metallisierung von Durchkontaktierungen keinerlei Schwierigkeiten. Ferner ist hervorzuheben, daß die erfindungsgemäße Bildstrukturierung mittels elektromagnetischer Strahlung auch eine besonders einfache Herstellung von dreidimensionalen spritzgegossenen Leiterplatten ermöglicht.

Bei der Verwendung von PdCl$_2$-SnCl$_2$ als Bekeimung konnten besonders gute Ergebnisse bei der nachfolgenden selektiven Ablation erzielt werden. Die Verwendung palladiumorganischer Verbindungen als Bekeimung hat sich ebenfalls als besonders vorteilhaft erwiesen. Bei derartigen palladiumorganischen Verbindungen handelt es sich um handelsübliche Bäder für die Additivtechnik.

Gemäß einer weiteren bevorzugten Ausgestaltung der Erfindung wird die Ablation nach dem Aufbringen der Bekeimung und vor dem Aktivieren vorgenommen. Neben einer Mengenreduzierung der benötigten Bäder wird hierdurch insbesondere auch Umweltschutzgesichtspunkten Rechnung getragen.

Bei der Verwendung von Substraten aus glasfaserverstärktem Polyetherimid wird die Oberfläche durch Ablation allenfalls nur geringfügig beeinträchtigt. Andererseits ist glasfaserverstärktes Polyetherimid für die Herstellung dreidimensionaler spritzgegossener Leiterplatten besonders gut geeignet.

Im Hinblick auf die für die Ablation der Bekeimung, der aktivierten Bekeimung oder der dünnen Grundschicht erforderliche Photonenenergie hat sich die Verwendung eines UV-Lasers als besonders günstig herausgestellt, wobei hier auch die Vorteile der Laser-Bildübertragung realisiert werden können. Die Ablation mit Hilfe eines vorzugsweise gepulsten Eximer Lasers hat dabei zu den besten Ergebnissen geführt.

Ausführungsbeispiele der Erfindung sind in der Zeichnung dargestellt und werden im folgenden näher beschrieben.

Es zeigen in stark vereinfachter schematischer Darstellung

Fig. 1 bis Fig. 5 verschiedene Verfahrensstadien bei der erfindungsgemäßen Herstellung von Leiterplatten

Fig. 6 bis Fig. 10 eine erste Variante des anhand der Fig. 1 bis 5 aufgezeigten Verfahrens,

Fig. 11 bis Fig. 14 eine zweite Variante des anhand der Fig. 1 bis 5 aufgezeigten Verfahrens und

Fig. 15 die Prinzipskizze einer Anordnung zur Laser- Bildübertragung.

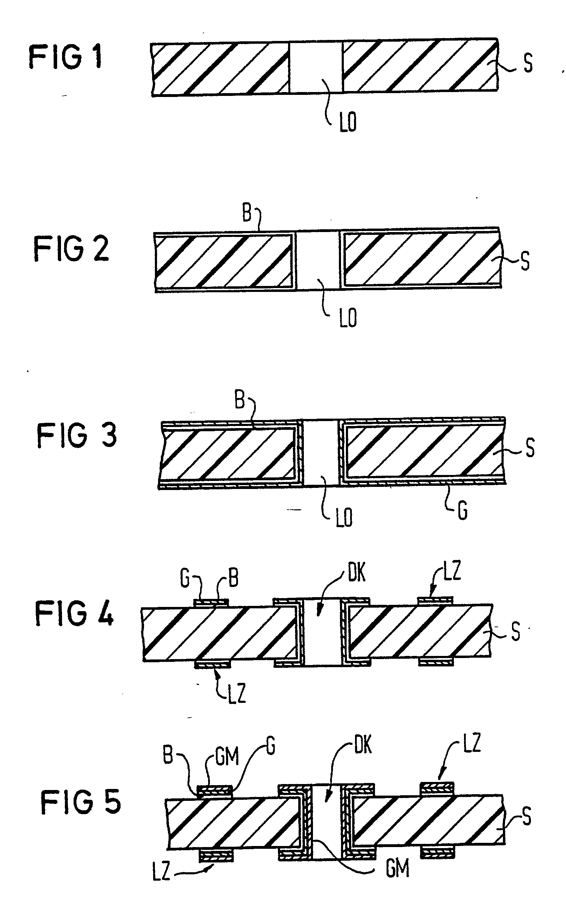

Bei dem in Fig. 1 dargestellten Substrat S handelt es sich um einen Ausschnitt eines Basismaterials für eine dreidimensionale spritzgegossene Leiterplatte mit eingespritzten Löchern LO. Als Materialien für derartige Leiterplatten sind insbesondere hochtemperaturbeständige Thermoplaste geeignet, wobei im geschilderten Ausführungsbeispiel glasfaserverstärktes Polyetherimid verwendet wurde.

Das in Fig. 1 dargestellte Substrat S wurde zunächst zur Erhöhung der Haftfestigkeit der später aufzubringenden Leiterzüge und Durchkontaktierungen gebeizt und anschließend gereinigt. Dabei wurden sowohl für das Beizen als auch für die Reinigung des Substrats S handelsübliche Bäder verwendet, wobei das Beizbad speziell auf den Werkstoff Polyetherimid abgestimmt war.

Nach dem Beizen und Reinigen des Substrats S erfolgte dessen Bekeimung, die in Fig. 2 als dünne Schicht B aufgezeigt ist. Es ist ersichtlich, daß eine Bekeimung B auf die Oberfläche des Substrats und die Wandungen der Löcher LO aufgebracht wurde. Das Aufbringen der Bekeimung B erfolgte durch Eintauchen des Substrats S in ein $PdCl_2$-$SnCl_2$-Bad. Für das Aufbringen der Bekeimung B haben sich aber auch handelsübliche Bäder auf der Basis palladiumorganischer Verbindungen als geeignet erwiesen.

Nach dem Aufbringen der Bekeimung B wird diese aktiviert, wobei es sich hier um ein in der Additivtechnik übliches Reduzieren bzw. Beschleunigen handelt. Anschließend wurde gemäß Fig. 3 durch außenstromlose chemische Metallabscheidung eine äußerst dünne Grundschicht G aufgebracht. Es ist ersichtlich, daß auch diese in einem handelsüblichen stromlosen Kupferbad aufgebrachte Grundschicht G die Oberfläche des Substrats S und die Wandungen der Löcher LO überzieht.

Nach dem Aufbringen der dünnen Grundschicht G wird diese gemäß Fig. 4 in den nicht den späteren Leiterzügen LZ und späteren Durchkontaktierungen DK entsprechenden Bereichen des Substrats S wieder entfernt. Diese selektive Entfernung der Grundschicht G, die der Erzeugung eines negativen Leiterbildes entspricht wird durch Ablation mittels elektromagnetischer Strahlung vorgenommen. Bei dieser Ablation, die an späterer Stelle anhand der Fig. 15 näher erläutert wird, wird auch gleichzeitig gemäß Fig. 4 die Bekeimung B in den nicht den späteren Leiterzügen LZ bzw. späteren Durchkontaktierungen DK entsprechenden Bereichen wieder abgetragen.

Zur Fertigstellung der Leiterzüge LZ und der Durchkontaktierungen DK wird dann gemäß Fig. 5 eine galvanische Verstärkung der nach der Ablation verbliebenen Grundschicht G vorgenommen. Das aus einem handelsüblichen Kupferbad im Bereich der Leiterzüge LZ und Durchkontaktierungen DK galvanisch abgeschiedene Metall ist in Fig. 5 mit GM bezeichnet.

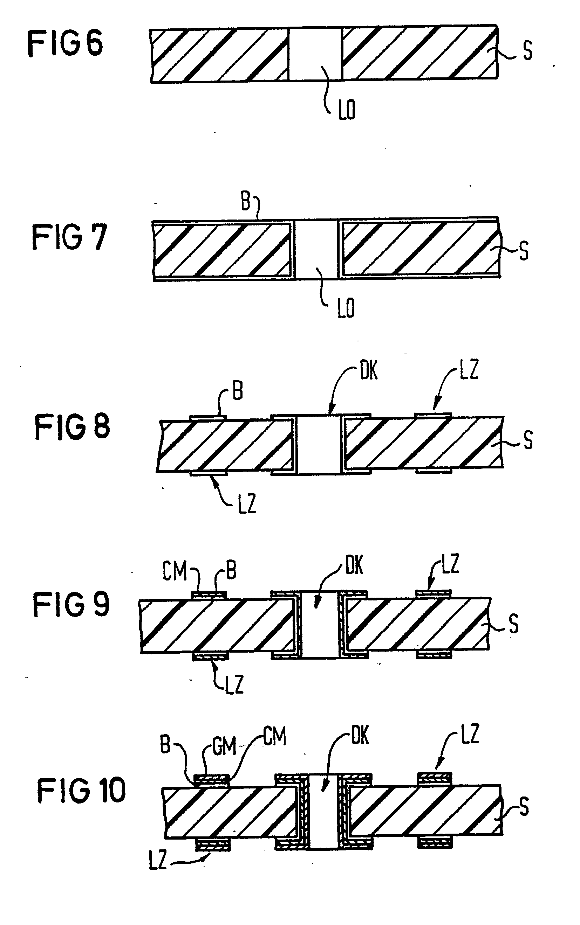

Bei der anhand der Fig. 6 bis 10 aufgezeigten Verfahrensvariante wird wieder von dem in Fig. 6 dargestellten Substrat S mit Löchern LO ausgegangen, auf welches dann gemäß Fig. 7 wieder eine Bekeimung B aufgebracht wird.

Vor oder nach dem Aktivieren der Bekeimung B wird diese dann durch Ablation mittels elektromagnetischer Strahlung selektiv wieder entfernt. Gemäß Fig. 8 verbleibt die Bekeimung B dann nur noch in den Bereichen der späteren Leiterzüge LZ und der späteren Durchkontaktierungen DK.

Nach der selektiven Ablation der Bekeimung B wird dann gemäß Fig. 9 im Bereich der späteren Leiterzüge LZ und der späteren Durchkontaktierungen DK eine dünne Schicht chemisch abgeschiedenen Metalls CM aufgebracht. Bei dem Metall CM handelt es sich auch hier wieder um stromlos abgeschiedenes Kupfer.

Gemäß Fig. 10 werden zur Fertigstellung der Leiterplatten die Leiterzüge LZ und die Durchkontaktierungen DK galvanisch verstärkt, wobei das galvanisch abgeschiedene Metall wieder mit GM bezeichnet ist.

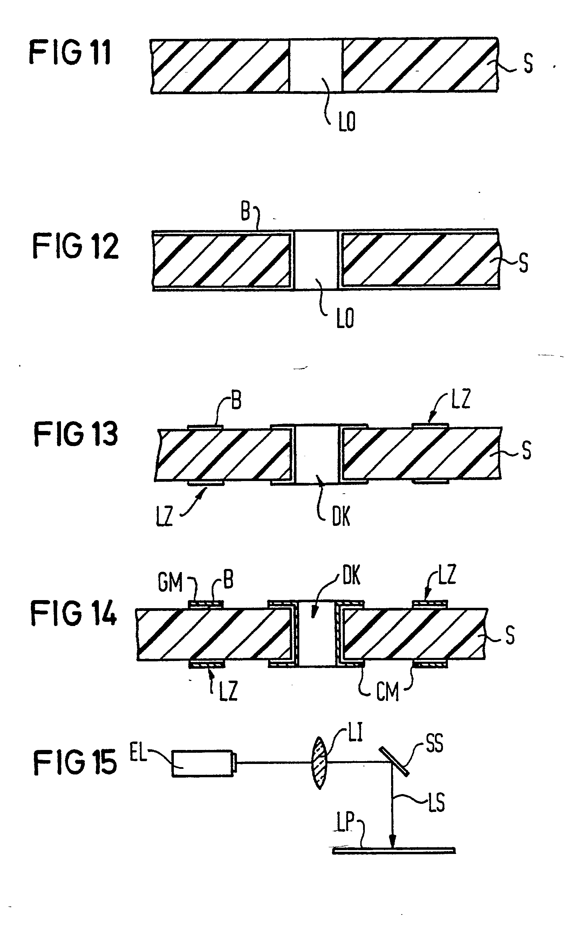

Bei der anhand der Fig. 11 bis 14 aufgezeigten Verfahrensvariante wird wieder von dem in Fig. 11 aufzeigten Substrat S mit Löchern LO ausgegangen, auf welches gemäß Fig. 12 wieder eine Bekeimung B aufgebracht wird. Vor oder nach dem Aktivieren der Bekeimung B wird diese dann wieder durch Ablation mittels elektromagnetischer Strahlung selektiv entfernt. Die verbleibende Bekeimung B im Bereich der späteren Leiterzüge LZ und der späteren Durchkontaktierungen DK ist in Fig. 13 aufgezeigt.

Nach der selektiven Ablation der Bekeimung B werden dann gemäß Fig. 14 die Leiterzüge LZ und die Durchkontaktierungen DK in einem Zuge durch chemische Metallabscheidung aufgebaut. Dabei ist in Fig. 14 die chemisch abgeschiedene Metallschicht wieder mit CM bezeichnet. Bei diesem chemisch abgeschiedenen Metall CM handelt es sich um eine aus einem handelsüblichen Kuperbad stromlos abgeschiedene Dickverkupferung.

Fig. 15 zeigt eine Prinzipskizze einer Anordnung zur Laser-Bildübertragung. Es ist ein Eximer Laser EL zu erkennen, dessen Laserstrahl LS über eine Linse LI und einen Schwingspiegel SS auf die Leiterplatte LP gelenkt wird und auf der Leiterplatte LP ein negatives Leiterbild erzeugt. Der Eximer Laser EL weist eine Wellenlänge von $\lambda = 248$ nm auf. Für eine einwandfreie selektive Ablation der Bekeimung B und der Grundschicht G gemäß Fig. 3 oder der Bekeimung B gemäß der Fig. 7 oder 12 wurde eine Energieeinstellung von 400 mJ pro Puls bei 1Hz Wiederholrate verwendet. Von den genannten Schichten wurden dabei etwas 0,5 Mikron pro Laserpuls abgetragen.

Anstelle der in Fig. 15 schematisch dargestellten Anordnung kann dem Eximer Laser EL auch ein Pattern Generator nachgeordnet werden. Zwischen dem Pattern Generator und der Leiterplatte wird dann eine Linse angeordnet. Die Bildstrukturierung erfolgt in diesem Fall durch entsprechende Verschiebungen und Drehungen der Leiterplatte gegenüber dem Patterngenerator.

Auch eine derartige Laser-Bildübertragung unter Verwendung eines Pattern Generators kann bei der Massenfertigung spritzgegossener Leiterplatten mit Vorteil eingesetzt werden.

**Patentansprüche**

1. Verfahren zur Herstellung von Leiterplatten in Additivtechnik, bei welchem das Leitermaterial durch Bekeimen, Aktivieren und nachfolgende chemische oder chemische und galvanische Metallabscheidung auf ein elektrisch isolierendes Substrat aufgebracht wird, dadurch gekennzeichnet, daß in den nicht den Leiterzügen (LZ) und/oder Durchkontaktierungen (DK) entsprechenden Bereichen des Substrats (S) die Bekeimung (B) allein oder zusammen mit einer dünnen durch chemische Metallabscheidung aufgebrachten Grundschicht (G) durch Ablation mittels elektromagnetischer Strahlung wieder entfernt wird und daß dann das Leitermaterial durch chemische und/oder galvanische Metallabscheidung aufgebracht wird.

2. Verfahren nach Anspruch 1, dadurch gekennzeichnet, daß als Bekeimung (B) PdCl₂-SnCl₂ verwendet wird.

3. Verfahren nach Anspruch 1, dadurch gekennzeichnet, daß als Bekeimung (B) eine palladiumorganische Verbindung verwendet wird.

4. Verfahren nach einem der vorhergehenden Ansprüche, dadurch gekennzeichnet, daß die Ablation nach dem Aufbringen der Bekeimung (B) und vor dem Aktivieren vorgenommen wird.

5. Verfahren nach einem der vorhergehenden Ansprüche, dadurch gekennzeichnet, daß ein Substrat (S) aus glasfaserverstärktem Polyetherimid verwendet wird.

6. Verfahren nach einem der vorhergehenden Ansprüche, dadurch gekennzeichnet, daß die Ablation mit Hilfe UV-Lasers vorgenommen wird.

7. Verfahren nach Anspruch 6, dadurch gekennzeichnet, daß die Ablation mit Hilfe eines Excimer Lasers (EL) vorgenommen wird.

8. Verfahren nach Anspruch 7, dadurch gekennzeichnet, daß ein gepulster Excimer Laser (EL) verwendet wird.

## Claims

1. Process for manufacturing printed circuit boards using additive technology, in which the conductor material is applied to an electrically insulating substrate by nucleation, activation and subsequent electroless deposition or electroless deposition and electrodeposition of metal, characterized in that the nucleation (B) in the regions of the substrate (S) that do not correspond to the conductor tracks (LZ) and/or plated-through holes (DK) is removed again on its own or together with a thin base coating (G), applied by electroless deposition of metal, by ablation by means of electromagnetic radiation, and in that the conductor material is then applied by electroless deposition and/or electrodeposition of metal.

2. Process according to claim 1, characterized in that PdCl₂-SnCl₂ is used as nucleation (B).

3. Process according to claim 1, characterized in that an organopalladium compound is used as nucleation (B).

4. Process according to one of the preceding claims, characterized in that the ablation is carried out after the application of the nucleation (B) and before the activation.

5. Process according to one of the preceding claims, characterized in that a substrate (S) made of fibre glass-reinforced polyether imide is used.

6. Process according to one of the preceding claims, characterized in that the ablation is carried out with the aid of a UV laser.

7. Process according to claim 6, characterized in that the ablation is carried out with the aid of an excimer laser (EL).

8. Process according to claim 7, characterized in that a pulsed excimer laser (EL) is used.

## Revendications

1. Procédé pour fabriquer des plaquettes à circuits imprimés selon la technique additive, et selon lequel on dépose un matériau conducteur par ensemencement de germes, activation et dépôt chimique ou chimique et galvanique ultérieur d'un métal sur un substrat électriquement isolant, caractérisé par le fait que, dans les zones du substrat (S) qui ne correspondent pas aux voies conductrices (LZ) et/ou aux contacts traversants (DK), on élimine l'ensemencement (B) seul ou conjointement avec une mince couche de base (G) déposée au moyen d'un dépôt chimique d'un métal, par ablation à l'aide d'un rayonnement électromagnétique et qu'on dépose ensuite le matériau conducteur au moyen d'un dépôt chimique et/ou galvanique d'un métal.

2. Procédé suivant la revendication 1, caractérisé par le fait qu'on utilise du PdCl₂-SnCl₂ comme ensemencement (B).

3. Procédé suivant la revendication 1, caractérisé par le fait qu'on utilise un composé organique du palladium comme ensemencement (B).

4. Procédé suivant l'une des revendications précédentes, caractérisé par le fait qu'on réalise l'ablation après le dépôt de l'ensemencement (B) et avant l'activation.

5. Procédé suivant l'une des revendications précédentes, caractérisé par le fait qu'on utilise un substrat (S) formé d'un polyétherimide renforcé par des fibres de verre.

6. Procédé suivant l'une des revendications précédentes, caractérisé par le fait qu'on exécute l'ablation à l'aide d'un laser à ultraviolet.

7. Procédé suivant la revendication 6, caractérisé par le fait qu'on réalise l'ablation à l'aide d'un laser excimère (EL).

8. Procédé suivant la revendication 7, caractérisé par le fait qu'on utilise un laser excimère pulsé (EL).

FIG 1

FIG 2

FIG 3

FIG 4

FIG 5

FIG 6

FIG 7

FIG 8

FIG 9

FIG 10

FIG 11

FIG 12

FIG 13

FIG 14

FIG 15